# EUROPÄISCHE PATENTSCHRIFT

(11) **EP 2 257 147 B1**
(45) Veröffentlichungstag und Bekanntmachung des Hinweises auf die Patenterteilung: **05.12.2012**
(21) Anmeldenummer: 09011455.4
(22) Anmeldetag: 08.09.2009
(51) Int. Cl.: H05K 7/20

(54) **Kühlgerät**
Cooler unit
Appareil frigorifique

(30) Priorität: 13.05.2009 DE 202009006916 U
(43) Veröffentlichungstag der Anmeldung: 01.12.2010
(73) Patentinhaber: Pfannenberg GmbH, 21035 Hamburg (DE)
(72) Erfinder: Pfannenberg, Andreas, 21035 Hamburg (DE)
(74) Vertreter: Richter Werdermann Gerbaulet Hofmann

(56) Entgegenhaltungen:
- EP-A2- 1 448 040
- DE-U1- 29 908 370
- US-A1- 2004 148 948
- US-B1- 6 182 742

## Beschreibung

### Technisches Gebiet

Die Erfindung betrifft ein Kühlgerät nach dem Oberbegriff des Anspruches 1.

Bei Gehäusen mit Abwärme erzeugenden Bauteilen, wie Elektronik-Schrank, Schaltschrank, Gehäusesysteme oder Computersysteme, besteht das Problem, dass eine Wärmeabfuhr umso schwieriger wird, je höher eine IP-Schutzart für das Gehäuse gewünscht ist. Besonders schwierig ist daher die Wärmeabfuhr bei Outdoorgeräten, die besonders gegen Staub, Schmutz und Wassereintritt abgedichtet sein müssen, damit die Funktion elektronischer oder anderer Baugruppen nicht beeinträchtigt wird.

### Stand der Technik

Bekannt sind aktive Kühlsysteme für Schaltschränke. Diese weisen einen Kühlkreislauf mit einem Kältemittel auf, der eine Kühlung durch ein Kompressor-Verdampfungsprinzip bewirkt. Zwar kann eine hohe Kühlleistung durch ein solches Kühlsystem bereitgestellt werden, von Nachteil ist jedoch sein hoher Energieverbrauch.

In der DE 299 08 370 U1 wird eine Vorrichtung zum Kühlen eines Schalt- oder Steuerschrankes beschrieben. Die Kühlvorrichtung besteht aus einem Luft-Lust-Kühlsystem sowie einem thermodynamischen Kühlsystem.

Aus der US 2004/0148948 A1 ist ein Kühlsystem bekannt, welches aus verschiedenen Modi besteht. Dabei ist das Kühlsystem in einem Gehäuse mit Abwärme erzeugenden Bauteilen zur Kühlung der Innenluft angeordnet.

In der EP 1 448 040 A2 wird ein Kühlsystem beschrieben, welches mit flüssigem Kühlmittel arbeitet und zur Kühlung mehrerer Server-Module geeignet ist.

Aus der US 6,182,742 B1 ist ebenfalls ein Kühlsystem bekannt, welches mit flüssigem Kühlmittel arbeitet. Dabei besteht das Kühlsystem aus zwei getrennten Kontrolleinheiten sowie mehreren parallel zueinander angeordneten Kühleinheiten.

### Darstellung der Erfindung: Aufgabe, Lösung, Vorteile

Der Erfindung liegt die Aufgabe zugrunde, ein Kühlgerät zu schaffen, dass eine effektive Kühlung bei deutlich geringerem Energieverbrauch erreicht.

Diese Aufgabe wird durch ein Kühlgerät mit den Merkmalen des Anspruches 1 gelöst. Vorteilhafte Weiterbildungen der Erfindung sind in den Unteransprüchen gekennzeichnet.

Die Erfindung beruht auf dem Gedanken, einen aktiven Kühlkreislauf derart mit einem passiven Kühlkreislauf zu kombinieren, dass das aktive System praktisch nur bei hoher Abwärme und/oder hoher Umgebungstemperatur zugeschaltet wird.

Das Verfahren zum Kühlen eines Gehäuses mit Abwärme erzeugenden Bauteilen, wie Elektronik-Schrank, Schaltschrank, Gehäusesysteme oder Computersysteme, unter Verwendung eines Kühlgerätes gemäß der Ansprüche 1 bis 14 besteht darin, dass bei Überschreiten einer vorgegebenen Kühltemperatur eines passiven Kühlsystems ein auf die vorgegebene Kühltemperatur des passiven Kühlsystems ein auf die vorgegebene Kühltemperatur herunterschaltbares aktives Kühlsystem eingeschaltet wird, wobei beide Kühlsysteme funktional zusammenarbeitend sind.

Die Kühlung wird durch einen kombinierten Wärmeaustauscher WT1 vorgenommen, der sowohl als Kondensator für das aktive (Kompressor) Kühlsystem sowie als Wärmeaustauscher für das passive Kühlsystem arbeitet.

Das Verfahren sieht ferner vor, dass das Kühlmittel des ersten Kühlkreises, wie Wasser, Wasser/Glykol-Gemisch oder Öl, durch ein erstes Magnetventil V1 bzw. ein zweites Magnetventil V2 gesteuert und bei passiver Kühlung durch den Wärmeaustauscher WT1 bei geöffnetem ersten Magnetventil V1 und bei geschlossenem zweiten Magnetventil V2 geführt wird sowie mittels Umgebungsluft durch den Ventilator auf Umgebungslufttemperatur + etwa 10 K abgekühlt wird, wobei bei Nichterreichen der Solltemperatur durch Auftreten höherer Umgebungstemperatur oder bei einem größeren Wärmeanfall der aktive Kühlkreis bei geschlossenem Ventil V1 und geöffnetem Ventil V2 zugeschaltet und das Kühlmittel über den Wärmeaustauscher (Verdampfer) WT2 mittels des Kältemittels auf die Solltemperatur gebracht wird, wobei die Regelung der Kühlung mittels elektronischer Thermostaten durchgeführt wird, dessen Fühler entweder in dem Behälter und/oder bei Zweifühlersystemen, in den zu kühlenden Komponenten kundenseitig angebracht werden.

Ferner sieht das Verfahren vor, dass der Kühlvorgang während des Betriebes immer mit dem passiven Kühlsystem begonnen wird, wobei bei Überschreiten der Solltemperatur des passiven Kühlsystems um etwa 2 K das Gerät automatisch auf das aktive Kühlsystem (Kompressor) umgeschaltet wird, wobei das Kühlmittel auf etwa 1 K unter Solltemperatur des passiven Kühlsystems abgekühlt wird, und wobei bei Erreichen dieser Temperatur der Kompressor und somit das aktive Kühlsystem abgeschaltet wird, und wobei bei erneutem Ansteigen der Temperatur der Kühlvorgang erneut mit Start des passiven Kühlsystems eingeleitet wird.

In Schwachlastzeiten mit geringem Kühlbedarf oder bei niedrigen Umgebungstemperaturen und bei nichtausreichendem passiven Kühlsystem wird das aktive Kühlsystem eingeschaltet.

Mit der Erfindung kann ein Klima- bzw. Kühlgerät geschaffen werden, das aufgrund der beiden Kühlsysteme eine hohe Energieeinsparung erreicht. Das passive Kühlsystem wird nur eingesetzt, wenn eine Kühlung des erwärmten Kühlmittels vermittels der Umgebungsluft ausreicht. Das aktive Kühlsystem dagegen wird nur dann eingesetzt bzw. automatisch zugeschaltet, wenn es nicht ausreicht, das hoch erwärmte Kühlmittel mit dem passiven Kühlsystem herunterzukühlen, so dass in einer ersten Verfahrensstufe das erwärmte Kühlmittel vermittels des passiven Kühlsystems heruntergekühlt wird, reicht das passive System nicht aus, die Temperatur zu halten, wird das aktive Kühlsystem zugeschaltet, um das Kühlmittel herunterzukühlen. Die Temperatur des Kühlmittels, beispielsweise Wasser oder ein Glykolgemisch, im Schaltschrank liegt bei z.B. etwa 25° C, die auf Umgebungslufttemperatur heruntergekühlt werden soll. Über eine Temperaturregelung, beispielsweise ein Thermostat, kann das Zuschalten des aktiven Kühlsystems gesteuert werden. Das Zuschalten des aktiven Kühlsystems erfolgt immer dann, wenn die Umgebungsluft des passiven Kühlsystems nicht ausreicht, um das erwärmte Kühlmittel herunterzukühlen. Es können ein erstes Ventil geschlossen und ein zweites Ventil geöffnet werden, so dass das Kühlmittel über einen Wärmetauscher mit Kühlgebläse umgeleitet werden kann und wobei ein Kompressor des aktiven Kühlsystems starten kann. Das passive Kühlsystem arbeitet mit Umgebungsluft. Das aktive Kühlsystem arbeitet mit einem Kälteaggregat. Insbesondere in den Nachtstunden wird nur mit dem passiven Kühlsystem gearbeitet, da die Umgebungsluft nachts eine niedrigere Temperatur als am Tage hat.

Ein weiterer Vorteil ist der geringe Stromaufwand und damit eine geringere Anschlussleistung sowie kleinere Komponenten, wie ein Kompressor mit geringerer Leistung. Durch die Erfindung kann eine 50 %-ige Energieeinsparung erreicht werden.

In der erfindungsgemäßen Vorrichtung ist vorgesehen, dass zwei separate Kühlkreisläufe vorhanden sind. Jeder Kühlkreislauf ist in sich geschlossen. Das passive Kühlsystem umfasst einen ersten Kühlkreislauf mit einem ersten, flüssigen Kühlmittel, vorzugsweise Wasser oder ein Glykolgemisch. Das aktive Kühlsystem umfasst einen zweiten Kühlkreislauf mit einem zweiten Kühlmittel, vorzugsweise einem Kältemittel. Das Kühlmittel unterscheidet sich vom Kältemittel, welches ein Kälteaggregat für Klimageräte in bekannter Weise haben kann. Dies hat den Vorteil, dass das Klimagerät nur einen Wasserzu- und -ablauf hat, weil das Kühlmittel, das einen Schaltschrank direkt über einen entsprechenden Wärmetauscher kühlt, Wasser sein kann. Ein Kältemittel mit einem Kälteaggregat tritt nicht aus dem Kühlgerätegehäuse aus.

Zweckmäßigerweise umfasst mindestens eines der Kühlsysteme ein Kühlgebläse. Vorzugsweise wird ein einziges Kühlgebläse für beide Systeme eingesetzt, was kostengünstiger ist. Dieser kann über, unter oder neben einen Wärmetauscher angeordnet sein, wobei durch den Wärmetauscher sowohl das Kühlmittel als auch das Kältemittel getrennt voneinander fließen können. Beide Mittel sind jedoch thermisch verbunden. Das erwärmte Kühlmittel kann durch das Kühlgebläse auf etwa Umgebungstemperatur heruntergekühlt werden.

Bewährt hat sich, wenn das aktive Kühlsystem einen Kältemittelverdampfer mit Kompressor umfasst. Dadurch kann das Klimagerät auch bei hohen Außentemperaturen und/oder hoher Abwärme im Schaltschrank gut arbeiten.

Eine thermische Kopplung beider Kühlkreisläufe kann zusätzlich oder alternativ dadurch erfolgen, dass ein zweiter, als Verdampfer ausgeführter Wärmetauscher vorhanden ist, der beide Kühlsysteme nur thermisch verbindet. Im Bedarfsfall kann das aktive System das Kühlmittel des passiven Systems kühlen.

Gemäß einer weiteren vorteilhaften Weiterbildung der Erfindung wird das Kältemittel des aktiven Kühlsystems soweit herabgekühlt bis es eine Temperatur hat, dass ein weiteres Abkühlen durch das passive Kühlsystem erfolgen kann, indem das Kältemittel auf Umgebungstemperatur herabgekühlt wird.

In z.B. einem Behältnis, wie ein Tank, befindet sich das flüssige und gekühlte Kältemittel, wie Wasser oder ein Wasser / Glykolgemisch, das dem Schaltschrank zugeführt wird. Im Innenraum des Schaltschrankes wird durch die elektrischen Bauteile Wärme erzeugt, durch die das dem Schaltschrank zugeführte Kühlmittel erwärmt wird. Das so erwärmte Kühlmittel wird dem passiven Kühlsystem zugeführt und hier auf Umgebungstemperatur heruntergekühlt. Das passive Kühlsystem weist einen Wärmeaustauscher auf, wobei die Kühlung mittels des Gebläses bzw. Ventilators vorgenommen wird. Das Kühlmittel durchströmt den Wärmeaustauscher, dem Kühlluft vermittels des Ventilators zugeführt wird, der Umgebungsluft als Kühlmittel dem Wärmeaustauscher zuführt. Das auf Umgebungslufttemperatur heruntergekühlte Kühlmittel strömt dann wieder in das Behältnis zurück und von dort strömt das auf Umgebungsluft gekühlte Kühlmittel wieder zum Schaltschrank, um über einen Wärmeaustauscher die im Innenraum erwärmte Luft herunterzukühlen.

Es kann jedoch der Zustand eintreten, dass das passive Kühlsystem nicht ausreicht, um das vom Schaltschrank kommende hoch erwärmte Kühlmittel wieder herunterzukühlen. Hier kommt dann das aktive Kühlsystem zum Einsatz. Das Kühlmittel wird vermittels des Verdampfers und des Kompressors unmittelbar soweit herabgekühlt, bis das Kältemittel eine Temperatur erreicht hat, die in etwa der Temperatur entspricht, die das Kühlmittel hat, wenn es dem passiven Kühlsystem zugeführt wird, so dass dann ein weiteres Abkühlen des Kältemittels im passiven Kühlsystem erfolgt, indem nämlich das Kältemittel auf Umgebungslufttemperatur herabgekühlt wird. Die Steuerung der Strömungsrichtung des Kühlmittels zu den beiden Kühlsystemen kann mittels Ventilen und Pumpen erfolgen. Temperatursonden können die Temperaturen steuern.

In einer weiteren bevorzugten Ausführungsform der Erfindung startet das passive Kühlsystem automatisch ab einer vorgegebenen, ersten Temperatur automatisch. Das aktive Kühlsystem startet ab einer vorgegebenen, zweiten Temperatur. Die zweite Temperatur ist höher, insbesondere etwa 2 - 10 K höher, als die erste Temperatur. Hierbei wird das aktive Kühlsystem wieder abgeschaltet wenn die Ist-Temperatur unter der ersten Temperatur abfällt, insbesondere um etwa 1-2 K darunter abfällt. Ab einer Temperatur (erster Schwellwert) startet der passive Kühler durch eine Pumpe. Steigt die Temperatur weiter, schaltet das Gerät bei dem zweiten Schwellwert auf aktive Kühlung um. Beispielsweise läuft die aktive Kühlung bis 1-2 K unter dem ersten Schwellwert und schaltet dann wieder ab. Eine Regelgenauigkeit sollte etwa +/- 1,5 Kbetragen. Ein ΔT passiv/aktiv kann z.B. 4 K betragen.

Bei einer passiven Kühlung ist ein ΔT von mindestens 10° K erforderlich, um eine maximale Kühlleistung zu erreichen.

Das Kühlmittel hat in einem ersten Beispiel im Behältnis eine Temperatur von z.B. 15° C (Umgebungslufttemperatur). Im Schaltschrank wird das Kühlmittel auf 25° C erwärmt. Im passiven Kühlsystem wird dann das Kühlmittel wieder auf 15° C (Umgebungslufttemperatur) herabgekühlt.

In einem zweiten Beispiel hat das Kühlmittel im Behältnis eine Temperatur von 15° C (Umgebungslufttemperatur). Im Schaltschrank wird das Kühlmittel auf 30° C erwärmt. Vermittels des aktiven Kühlsystems wird das auf 30° C erwärmte Kühlmittel auf 25° C herabgekühlt. Das Kühlmittel hat dann eine Temperatur von 25° C. Dieses Kühlmittel wird dann vermittels des passiven Kühlsystems auf Umgebungsluft z. B. 15° C herabgekühlt und gelangt mit einer Temperatur von 15° C wieder in das Behältnis.

Zweck des aktiven Kühlsystems ist es, Kühlmittel, das hoch erwärmt wird, so weit herunterzukühlen, und zwar bis auf eine Temperatur, die vermittels des passiven Kühlsystems der Temperatur der Umgebungsluft entspricht.

Vorteilhaft ist es, wenn im Behältnis, insbesondere im Kühlmitteltank, des passiven Kühlsystems, ein Temperatursensor zur Messung der Kühlmitteltemperatur angeordnet ist. Der Temperatursensor ist an einer Steuereinrichtung zur Steuerung eines Kompressors und/oder mindestens eines Ventils angeschlossen. Durch Temperaturmessung der in dem Tank befindlichen Flüssigkeit kann eine stabile Regelstruktur geschaffen werden. Maßgeblich für eine Regelung ist die Temperatur des Kühlmittels.

Sehr günstig ist es, dass das Kühlgerätegehäuse eine externe Kühlmittelleitung für erwärmtes Kühlmittel und eine externe Kühlmittelleitung für gekühltes Kühlmittel umfasst, wobei diese Leitungen mit einem außerhalb des Kühlgerätegehäuses angeordneten Wärmetauscher für das zu kühlende Gehäuse, wie Schaltschrankgehäuse und dergleichen, vorgesehen sind, und wobei der Kühlkreislauf des aktiven Kühlsystems vollständig im Kühlgerätegehäuse untergebracht ist. Beide Kühlmittelleitungen können mit einem Wärmetauscher im Schaltschrank in einfacher Weise verbunden werden. Das Gerät benötigt insgesamt nur zwei externe Leitungen für beide Kühlsysteme. Pumpendruckseitig können Schläuche mit gepressten Anschlussstutzen verwendet werden.

Von Vorteil ist eine Verwendung des Kühlgerätes in einem Outdoorgerät. Dieses kann mit einer speziellen Farbgebung versehen sein. Eine Winterregelung bis - 30°C für den Kältekreis ist zweckmäßig. Zusätzlich kann ein externer Temperaturfühler für eine Lufteintrittstemperatur vorhanden sein. Die Kühlleistung des aktiven Systems kann z.B. 6 - 10 kW betragen. Denkbar ist auch eine Kühlung von Umrichtern, Synschronmotoren für Pressen, Abkantbänke und dergleichen.

Ein Ausführungsbeispiel wird anhand der Zeichnungen näher erläutert, wobei weitere vorteilhafte Weiterbildungen der Erfindung und Vorteile derselben beschrieben sind. Es zeigen in schematischer Darstellung:
- Fig. 1: eine Darstellung eines Kühlkreislaufes eines erfindungsgemäßen Kühlgerätes,
- Fig. 2: ein Kühlgerät in perspektivischer Darstellung, und
- Fig. 3: Leistungskurven in einem aktiven Kühlbetrieb.

### Bester Weg zur Ausführung der Erfindung

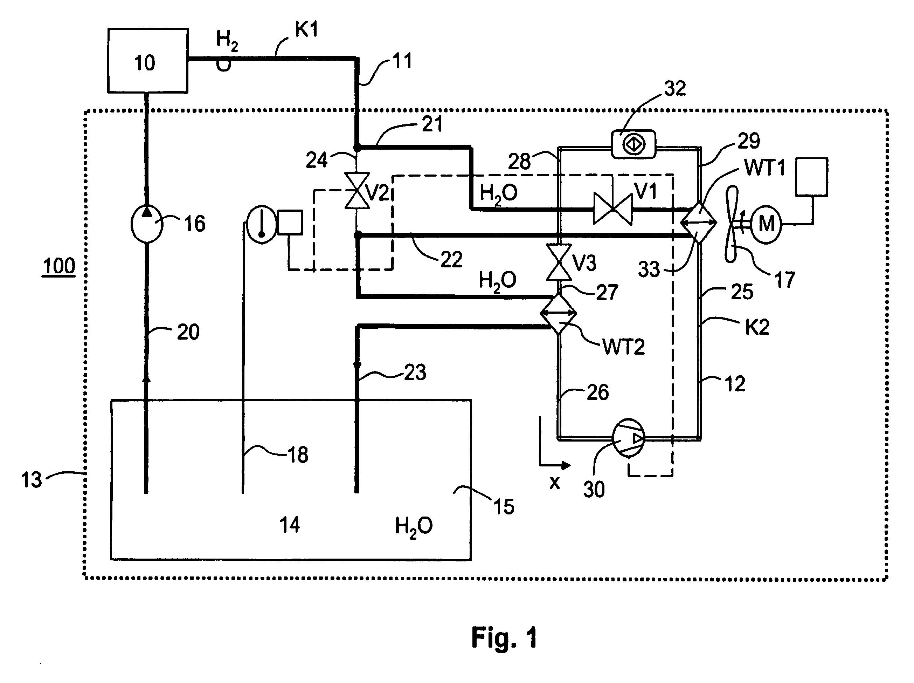

Fig. 1 zeigt ein Kreislaufsystem eines Kühlgerätes 100 für ein Gehäuse mit Abwärme erzeugenden Bauteilen, wie Elektronik-Schrank, Schaltschrank, Gehäusesysteme oder Computersysteme. Hier soll ein Schaltschrank 10 (Kühlstelle) gekühlt werden.

Das System umfasst ein passives Kühlsystem 11 mit einem Kühlmittel und ein aktives Kühlsystem 12 mit einem Kältemittel, und zwar das mit vorgegebener Kühltemperatur arbeitende passive Kühlsystem und das bei Überschreiten der vorgegebener Kühltemperatur des passiven Kühlsystems 11 einschaltbare, auf die vorgegebene Kühltemperatur herunterschaltbare aktive Kühlsystem 12.

Beide Kühlsysteme sind in einem Kühlgerätegehäuse 13 untergebracht, wie die punktierte Linie in Fig. 1 veranschaulicht.

Das passive Kühlsystem 11 hat einen ersten Kühlkreislauf K1 mit einem ersten, flüssigen Kühlmittel 14, vorzugsweise Wasser oder ein Glykosegemisch. Das Kühlmittel befindet sich in einem Behälter 15 bzw. Ausdehnungsgefäß. Über den Leitungsabschnitt 20 wird das Kühlmittel durch eine Pumpe 16 in den Schaltschrank bzw. einen Wärmetauscher gepumpt. Die Pumpe 16 startet ab einer Temperatur T1 des Kühlmittels im Behälter von mindestens 15°C. Im Schaltschrank steigt die Temperatur des Kühlmittels. Durch einen Leitungsabschnitt 21 wird über ein Ventil V1 das Kühlmittel einem Wärmetauscher WT1 mit Kühlgebläse 17, der mit einem elektromotor-angetriebenen Radial- oder Axiallüfter versehen ist, zugeführt und passiv gekühlt. Ein weiterer Leitungsabschnitt 22 verbindet den ersten Wärmetauscher WT1 mit einem zweiten Wärmetauscher WT2, der mit dem passiven Kühlsystem 11 verbunden ist. Durch den Leitungsabschnitt 23 gelangt das Kühlmittel wieder in den Behälter 15.

Im Behälter 15 ist ein Temperatursensor 18 zur Messung der Kühlmitteltemperatur angeordnet. Der Temperatursensor 18 ist an einer Steuereinrichtung zur Steuerung eines Kompressors 30, des ersten Ventils V1 und eines zweiten Ventils V2 angeschlossen, wie die gestrichelten Linien zeigen. Das zweite Ventil V2 ist in einem Bypass-Leitungsabschnitt 31 des ersten Kreislaufs K1 eingebaut, so dass das Kühlmittel nicht über den ersten Wärmetauscher WT1, sondern direkt in den Behälter 15 zurückfließt. Das zweite Ventil V2 öffnet nur bei niedriger Temperatur, wobei dann das erste Ventil V1 geschlossen wird.

Das aktive Kühlsystem umfasst einen zweiten Kühlkreislauf K2 mit einem Kältemittel, wie es für Kühlschränke, Klimaanlagen und dgl. verwendet wird und welches sich vom Wasser bzw. einem Glykosegemisch unterscheidet. Ein Leitungsabschnitt 25 des Kreislaufs K2 verbindet den ersten Wärmetauscher WT1 mit dem Kompressor 30. Ein Leitungsabschnitt 26 verbindet dann den Kompressor 30 mit dem zweiten Wärmetauscher WT2, wobei das Kältemittel durch beide Wärmetauscher WT1, WT2 in von dem ersten passiven Kreislauf K1 bzw. Kühlmittel getrennten Leitungen fließt. Der zweite Wärmetauscher WT1 ist auch ein Verflüssiger bzw. Wärmeaustauscher 33 für das Kältemittel. Ein Leitungsabschnitt 27 verbindet den Verdampfer mit einem dritten Ventil V3, das den aktiven Kreislauf K2 bzw. Kältemittel schließen kann und dessen Steuerung von dem Verdampfungsprozess abhängt. Ein weiterer Leitungsabschnitt 28 verbindet das dritte Ventil V3 mit einer Pumpe oder einem Verflüssiger 32 bzw. der symbolisch eingezeichneten Komponente 32, die mit einem Leitungsabschnitt 29 mit dem ersten kombinierten Wärmetauscher WT1 verbunden ist. Pfeil x zeigt die Strömungsrichtung des Kältemittels.

Das durch den Schaltschrank 10 erwärmte Kühlmittel wird durch das Kühlgebläse bzw. Ventilator 17 auf etwa Umgebungstemperatur heruntergekühlt. Reicht diese Kühlung nicht aus, wird der Kompressor 30 eingeschaltet. In einer ersten Verfahrensstufe wird das erwärmte Kältemittel des aktiven Kühlsystems auf eine solche Temperatur heruntergekühlt, bis eine Temperatur erreicht wird, bei der nur das passive Kühlsystem einsetzt. In einer zweiten Verfahrensstufe wird nur ein Kühlmittel des passiven Kühlsystems nur mit Umgebungsluft heruntergekühlt.

Durch das gezeigte System wird erreicht, dass einerseits das passive Kühlsystem und das aktive Kühlsystem durch die Wärmetauscher WT1 und WT2 thermisch miteinander verbunden sind und andererseits, dass das Kältemittel des aktiven Kühlsystems soweit herabgekühlt wird, bis es eine Temperatur hat, dass ein weiteres Abkühlen durch das passive Kühlsystem erfolgen kann, indem das Kältemittel auf Umgebungstemperatur herabgekühlt wird.

Wird das zweite Ventil V2 geöffnet und das erste Ventil V1 geschlossen, fließt das Kühlmittel nicht über den Wärmetauscher WT1. Während der ersten Verfahrensstufe weist das Kühlmittel des passiven Kühlsystems durch die Ventile V1, V2 und der Pumpe 16 eine solche Strömungsrichtung auf, dass es nur durch das aktive Kühlsystem und nicht durch Umgebungsluft gekühlt wird. Die Kühlung des Kühlmittels erfolgt nur durch den zweiten Wärmetauscher WT2.

Alternativ kann das Kühlmittel gleichzeitig vom Kühlgebläse 17 und dem zweiten Wärmetauscher WT2 heruntergekühlt werden. Während der ersten Verfahrensstufe weist das Kühlmittel des passiven Kühlsystems die gleiche Strömungsrichtung auf wie in der zweiten Verfahrensstufe. Das Ventil V1 ist immer geöffnet bzw. könnte entfallen. Das Kühlmittel wird durch das aktive Kühlsystem und gleichzeitig durch Umgebungsluft gekühlt.

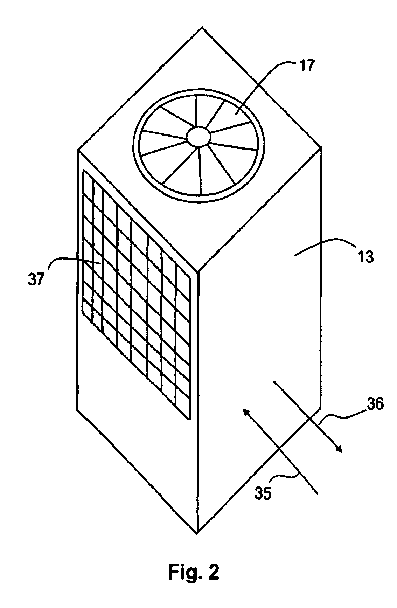

Fig. 2 zeigt, dass das Kühlgerätegehäuse 13 mit dem Kühlgebläse 17 und weiteren Lufteintrittsöffnungen 37. Es ist prinziphaft eingezeichnet, dass eine externe Kühlmittelleitung 35 für erwärmtes Kühlmittel und eine externe Kühlmittelleitung 36 für gekühltes Kühlmittel vorhanden sind. Diese Leitungen 35, 36 sind mit einem außerhalb des Kühlgerätegehäuses 13 angeordneten Wärmetauscher für den Schaltschrank 10 vorgesehen. Beide Kühlsysteme, d.h. die Kühlkomponenten der Systeme, sind im Wesentlichen vollständig im Kühlgerätegehäuse 13 untergebracht.

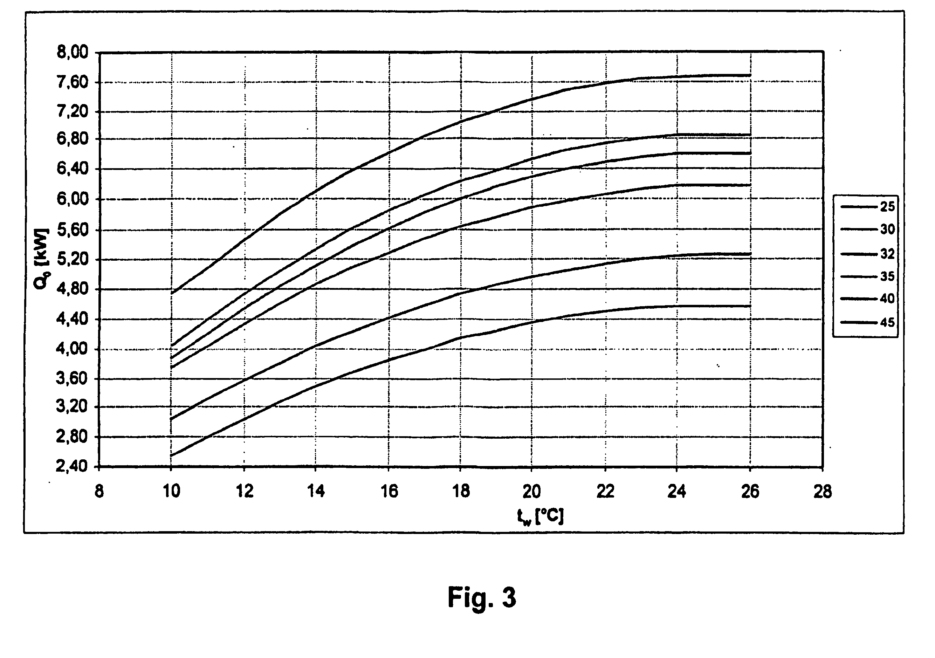

Fig. 3 zeigt Leistungsdaten im aktiven Kühlbetrieb, und zwar die Kühlleistung Q, die Kühlkapazität und die Wassertemperatur t_{w}. Sie zeigt praktisch beispielhaft die Wasser- bzw. Kühlmitteltemperatur in Abhängigkeit einer Schaltschranktemperatur von 25°C bis 45°C und von einer Kühlleistung im aktiven Kühlbetrieb von etwa 2,5 bis 7,7 kW. Die obere Kurve zeigt, dass bei einer Wassertemperatur von 15°C und einer Kühlleitung von 6,4 kW eine Schranktemperatur von 45°C heruntergekühlt werden kann. Die Wassertemperatur sollte 10°C nicht unterschreiten und 26°C nicht überschreiten.

Das erfindungsgemäß ausgebildete Kühlgerät wird wie folgt angewendet:

Bei Überschreiten einer vorgegebenen Kühltemperatur eines passiven Kühlsystems 11 wird ein auf die vorgegebene Kühltemperatur des passiven Kühlsystems ein auf die vorgegebene Kühltemperatur herunter schaltbares aktives Kühlsystem eingeschaltet, wobei beide Kühlsysteme 11, 12 funktional zusammenarbeitend sind.

Die Kühlung wird durch einen kombinierten Wärmeaustauscher WT1 vorgenommen, der sowohl als Kondensator für das aktive (Kompressor) Kühlsystem sowie als Wärmeaustauscher für das passive Kühlsystem arbeitet.

Das Kühlmittel des ersten Kühlkreises, wie Wasser, Wasser/GlykolGemisch oder Öl, wird durch ein erstes Magnetventil V1 bzw. ein zweites Magnetventil V2 gesteuert und bei passiver Kühlung durch den Wärmeaustauscher WT1 bei geöffnetem ersten Magnetventil V1 und bei geschlossenem zweiten Magnetventil V2 geführt, wobei mittels Umgebungsluft durch den Ventilator auf Umgebungslufttemperatur + etwa 10 K abgekühlt wird. Bei Nichterreichen der Solltemperatur durch Auftreten höherer Umgebungstemperatur oder bei einem größeren Wärmeanfall wird der aktive Kühlkreis bei geschlossenem Ventil V2 zugeschaltet. Das Kühlmittel wird über den Wärmeaustauscher (Verdampfer) WT2 mittels des Kältemittels auf die Solltemperatur gebracht. Die Regelung der Kühlung wird mittels elektronischer Thermostaten durchgeführt, dessen Fühler entweder in dem Behälter und/oder bei Zweifühlersystemen, in den zu kühlenden Komponenten kundenseitig angebracht werden.

Der Kühlvorgang wird während des Betriebes immer mit dem passiven Kühlsystem begonnen. Bei Überschreiten der Solltemperatur des passiven Kühlsystems um etwa 2 K wird das Gerät automatisch auf das aktive Kühlsystem (Kompressor) umgeschaltet, wobei das Kühlmittel auf etwa 1 K unter Solltemperatur des passiven Kühlsystems abgekühlt wird. Bei Erreichen dieser Temperatur wird der Kompressor und somit das aktive Kühlsystem abgeschaltet und bei erneutem Ansteigen der Temperatur wird der Kühlvorgang erneut mit Start des passiven Kühlsystems eingeleitet.

In Schwachlastzeiten mit geringem Kühlbedarf oder bei niedrigen Umgebungstemperaturen und bei nichtausreichendem passiven Kühlsystem wird das aktive Kühlsystem eingeschaltet.

### Bezugszeichenliste

- 10: Schaltschrank/Kühlstelle
- 11: passives Kühlsystem/Kühlmittel
- 12: aktives Kühlsystem/Kältemittel
- 13: Gehäuse
- 14: Kühlmittel
- 15: Behälter/Ausdehnungsgefäß
- 16: Pumpe
- 17: Gebläse/Ventilator
- 18: Temperatursensor

- 20 - 29: Leitungsabschnitte

- 30: Kompressor
- 32: Verflüssiger
- 33: Verflüssiger/Wärmetauscher
- 35: erste Leitung
- 36: zweite Leitung
- 37: Öffnungen

- V1 - V3: Ventile
- K1: passiver Kreislauf/Kühlmittel
- K2: aktiver Kreislauf/Kältemittel
- WT1: erster kombinierter Wärmeaustauscher
- WT2: zweiter Wärmetauscher

- 100: Kühlgerät

## Patentansprüche

1. Kühlgerät (100) für ein Gehäuse mit Abwärme erzeugenden Bauteilen, wie Elektronik-Schrank, Schaltschrank (10), Gehäusesysteme oder Computersysteme, wobei das Kühlgerät (100) ein passives Kühlsystem (11) und ein aktives Kühlsystem (12) aufweist,
wobei beide Kühlsysteme (11, 12) in einem Kühlgerätegehäuse (13) untergebracht sind, wobei das Kühlgerät (100) zwei separate Kühlkreisläufe (K1, K2) aufweist, wobei das passive Kühlsystem (11) einen ersten Kühlkreislauf (K1) mit einem ersten, flüssigen Kühlmittel, vorzugsweise Wasser oder ein Glykolgemisch, umfasst und das aktive Kühlsystem (12) einen zweiten Kühlkreislauf (K2) mit einem zweiten Kühlmittel, vorzugsweise einem Kältemittel, umfasst, **dadurch gekennzeichnet, dass** das passive Kühlsystem (11) mit vorgegebener Kühltemperatur arbeitet und dass das aktive Kühlsystem (12) bei Überschreiten der vorgegebenen Kühltemperatur des passiven Kühlsystems (11) einschaltet und auf die vorgegebene Kühltemperatur herunterschaltet,
wobei beide Kühlsysteme (11, 12) funktional zusammenarbeitend sind, wobei die Kühlung durch einen kombinierten Wärmetauscher (WT1) vorgenommen wird, der sowohl als Kondensator für das aktive Kühlsystem (12) sowie als Wärmetauscher für das passive Kühlsystem (11) arbeitet.

2. Kühlgerät nach Anspruch 1,
**dadurch gekennzeichnet,**
**dass** beide Kühlsysteme (11, 12) mit dem gleichen Ventilator (17) gekühlt werden.

3. Kühlgerät nach Anspruch 2,
**dadurch gekennzeichnet,**
**dass** das erwärmte Kühlmittel durch das Kühlgebläse (17) auf etwa Umgebungstemperatur +10 K heruntergekühlt wird.

4. Kühlgerät nach einem der vorhergehenden Ansprüche,
**dadurch gekennzeichnet,**
**dass** das passive Kühlsystem (11) und das aktive Kühlsystem (12) durch mindestens einen Wärmetauscher (WT1, WT2) thermisch verbunden sind.

5. Kühlgerät nach Anspruch 3 und 4,
**dadurch gekennzeichnet,**
**dass** das Kühlgebläse (17) zur Kühlung des Wärmetauschers (WT1) ausgeführt,ist.

6. Kühlgerät nach einem der vorhergehenden Ansprüche,
**dadurch gekennzeichnet,**
**dass** das aktive Kühlsystem (12) einen Kältemittelverdampfer (WT2) mit nachgeordnetem Kompressor (30) umfasst.

7. Kühlgerät nach einem der Ansprüche 4 bis 6,
**dadurch gekennzeichnet,**
**dass** ein zweiter, kombinierter Wärmetauscher/Kondensator (WT2) vorhanden ist, der beide Kühlsysteme thermisch verbindet.

8. Kühlgerät nach einem der vorhergehenden Ansprüche,
**dadurch gekennzeichnet,**
**dass** das Kühlmittel des passiven Kühlsystems (11) soweit herabgekühlt wird, bis es eine Temperatur hat, dass ein weiteres Abkühlen durch das aktive Kühlsystem (12) erforderlich macht, mit dem das Kühlmittel unter Umgebungstemperatur herabgekühlt werden kann.

9. Kühlgerät nach einem der vorhergehenden Ansprüche,
**gekennzeichnet durch** eine Ausführung derart, dass das passive Kühlsystem (11) automatisch ab einer vorgegebenen, ersten Temperatur (T1) automatisch startet, dass das aktive Kühlsystem (12) ab einer vorgegebenen, zweiten Temperatur (T2) startet, wobei die zweite Temperatur (T2) höher, insbesondere etwa 2 - 10 K höher als die erste Temperatur (T1) ist.

10. Kühlgerät nach Anspruch 9,
**dadurch gekennzeichnet,**
**dass** das aktive Kühlsystem (12) wieder abschaltet, wenn die Ist-Temperatur unter die erste Temperatur (T1) abfällt, insbesondere um etwa 1-2 K darunter abfällt.

11. Kühlgerät nach Anspruch 9 oder 10,
**dadurch gekennzeichnet,**
**dass** das Kühlmittel des passiven Kühlsystems durch das passive Kühlsystem alleine um mindestens 10 K abgekühlt wird.

12. Kühlgerät nach einem der vorhergehenden Ansprüche,
**gekennzeichnet durch** ein Behältnis (14) für das Kühlmittel des passiven Kühlsystems (11), in dem ein Temperatursensor (18) zur Messung der Kühlmitteltemperatur angeordnet ist, wobei der Temperatursensor an einer Steuereinrichtung zur Steuerung eines Kompressors (30) und der Ventile (V1, V2) angeschlossen ist.

13. Kühlgerät nach einem der vorhergehenden Ansprüche,
**dadurch gekennzeichnet,**
**dass** das Kühlgerätegehäuse eine externe Kühlmittelleitung (35) für erwärmtes Kühlmittel und eine externe Kühlmittelleitung (36) für gekühltes Kühlmittel umfasst, wobei diese Leitungen (35, 36) mit einem außerhalb des Kühlgerätegehäuses angeordneten Wärmetauscher für das zu kühlende Gehäuse, wie Schaltschrankgehäuse und dergleichen, vorgesehen sind, und wobei der Kühlkreislauf (K2) des aktiven Kühlsystems (12) vollständig im Kühlgerätegehäuse (13) untergebracht ist.

14. Verfahren zum Kühlen eines Gehäuses mit Abwärme erzeugenden Bauteilen, wie Elektronik-Schrank, Schaltschrank (10), Gehäusesysteme oder Computersysteme, unter Verwendung eines Kühlgerätes (100) gemäß Ansprüche 1 bis 13, wobei das Kühlgerät (100) ein passives Kühlsystem (11) und ein aktives Kühlsystem (12) aufweist, wobei das Kühlgerät (100) zwei separate Kühlkreisläufe (K1, K2) aufweist, wobei das passive Kühlsystem (11) einen ersten Kühlkreislauf (K1) mit einem ersten, flüssigen Kühlmittel, vorzugsweise Wasser oder ein Glykolgemisch, umfasst und das aktive Kühlsystem (12) einen zweiten Kühlkreislauf (K2) mit einem zweiten Kühlmittel, vorzugsweise einem Kältemittel, umfasst,
**dadurch gekennzeichnet,**
**dass** das passive Kühlsystem (11) mit vorgegebener Kühltemperatur arbeitet und dass das aktive Kühlsystem (12) bei Überschreiten der vorgegebenen Kühltemperatur des passiven Kühlsystems (11) einschaltet und auf die vorgegebene Kühltemperatur herunterschaltet, wobei beide Kühlsysteme (11, 12) funktional zusammenarbeitend sind, wobei die Kühlung durch einen kombinierten Wärmeaustauscher (WT1) vorgenommen wird, der sowohl als Kondensator für das aktive Kühlsystem sowie als Wärmeaustauscher für das passive Kühlsystem arbeitet.

15. Verfahren nach Anspruch 14,
**dadurch gekennzeichnet,**
**dass**
- das Kühlmittel des ersten Kühlkreises (1), wie Wasser, Wasser/Glykol-Gemisch oder Öl, durch ein erstes Magnetventil (V1) bzw. ein zweites Magnetventil (V2) gesteuert und bei passiver Kühlung durch den Wärmeaustauscher (WT1) bei geöffnetem ersten Magnetventil (V1) und bei geschlossenem zweiten Magnetventil (V2) geführt wird sowie mittels Umgebungsluft durch den Ventilator auf Umgebungslufttemperatur + etwa 10 K abgekühlt wird,
- bei Nichterreichen der Solltemperatur durch Auftreten höherer Umgebungstemperatur oder bei einem größeren Wärmeanfall der aktive Kühlkreis (12) bei geschlossenem Ventil (V1) und geöffnetem Ventil (V2) zugeschaltet und das Kühlmittel über den Wärmeaustauscher (Verdampfer) (WT2) mittels des Kältemittels auf die Solltemperatur gebracht wird, und
- die Regelung der Kühlung mittels elektronischer Thermostaten durchgeführt wird, dessen Fühler entweder in dem Behälter (15) und/oder bei Zweifühlersystemen, in den zu kühlenden Komponenten kundenseitig angebracht werden, wobei
- der Kühlvorgang während des Betriebes immer mit dem passiven Kühlsystem begonnen wird,
- bei Überschreiten der Solltemperatur des passiven Kühlsystems um etwa 2 K das Gerät automatisch auf das aktive Kühlsystem umgeschaltet wird, wobei das Kühlmittel auf etwa 1 K unter Solltemperatur des passiven Kühlsystems abgekühlt wird,
- bei Erreichen dieser Temperatur der Kompressor und somit das aktive Kühlsystem abgeschaltet wird, und
- bei erneutem Ansteigen der Temperatur der Kühlvorgang erneut mit Start des passiven Kühlsystems eingeleitet wird.

16. Verfahren nach einem der vorhergehenden Ansprüche 14 oder 15,
**dadurch gekennzeichnet,**
**dass** in Schwachlastzeiten mit geringem Kühlbedarf oder bei niedrigen Umgebungstemperaturen und bei nichtausreichendem passiven Kühlsystem das aktive Kühlsystem eingeschaltet wird.

17. Verwendung eines Kühlgerätes (100) nach einem der vorhergehenden Ansprüche 1 bis 13 in einem Outdoorgerät.

## Claims

1. Cooling device (100) for a housing comprising waste-heat-generating components such as electronics cabinet, switchgear cabinet (10), housing systems or computer systems, wherein the cooling device (100) comprises a passive cooling system (11) and an active cooling system (12),
wherein both cooling systems (11, 12) are disposed in a cooling device housing (13), wherein the cooling device (100) comprises two separate cooling circuits (K1, K2), wherein the passive cooling system (11) comprises a first cooling circuit (K1) with a first liquid coolant, preferably water or a glycol mixture and the active cooling system (12) comprises a second cooling circuit (K2) with a second coolant, preferably a refrigerant, **characterised in that** the passive cooling system (11) operates with predefined cooling temperature and that the active cooling system (12) switches on when the predefined cooling temperature of the passive cooling system (11) is exceeded and operates down to the predefined cooling temperature,
wherein both cooling systems (11, 12) are functionally cooperating, wherein the cooling is carried out by a combined heat exchanger (WT1), which operates both as condenser for the active cooling system (12) and as heat exchanger for the passive cooling system (11).

2. The cooling device according to claim 1,
**characterised in that**
both cooling systems (11, 12) are cooled with the same fan (17).

3. The cooling device according to claim 2,
**characterised in that**
the heated coolant is cooled down to approximately ambient temperature +10 K by the cooling fan (17).

4. The cooling device according to any one of the preceding claims,
**characterised in that**
the passive cooling system (11) and the active cooling system (12) are thermally connected by at least one heat exchanger (WT1, WT2).

5. The cooling device according to claim 3 and 4,
**characterised in that**
the cooling fan (17) is designed for cooling the heat exchanger (WT1).

6. The cooling device according to any one of the preceding claims,
**characterised in that**
the active cooling system (12) comprises a refrigerant evaporator (WT2) with a downstream compressor (30).

7. The cooling device according to any one of claims 4 to 6,
**characterised in that**
a second combined heat exchanger/condenser (WT2) is provided, which thermally connects both cooling systems.

8. The cooling device according to any one of the preceding claims,
**characterised in that**
the coolant of the passive cooling system (11) is cooled down until it has a temperature which necessitates a further cooling by the active cooling system (12), by which means the coolant can be cooled down below ambient temperature.

9. The cooling device according to any one of the preceding claims,
**characterised by** a design in such a manner that the passive cooling system (11) starts automatically from a predefined first temperature (T1), that the active cooling system (12) starts from a predefined second temperature (T2), wherein the second temperature (T2) is higher, in particular about 2-10 K higher than the first temperature (T1).

10. The cooling device according to claim 9,
**characterised in that**
the active cooling system (12) switches off again when the actual temperature decreases below the first temperature (T1), in particular decreases below by about 1-2 K.

11. The cooling device according to claim 9 or 10,
**characterised in that**
the coolant of the passive cooling system is cooled by the passive cooling system alone by at least 10 K.

12. The cooling device according to any one of the preceding claims,
**characterised by** a container (14) for the coolant of the passive cooling system (11) in which a temperature sensor (18) is disposed for measurement of the coolant temperature, wherein the temperature sensor is connected to a control device for controlling a compressor (30) and the valves (V1, V2).

13. The cooling device according to any one of the preceding claims,
**characterised in that**
the cooling device housing comprises an external coolant line (35) for heated coolant and an external coolant line (36) for cooled coolant, wherein these lines (35, 36) are provided with a heat exchanger disposed outside the cooling device housing for the housing to be cooled, such as switchgear cabinet housing and the like, and wherein the cooling circuit (K2) of the active cooling system (12) is desposed completely in the cooling device housing (13).

14. Method for cooling a housing comprising waste-heat-generating components such as electronics cabinet, switchgear cabinet (10), housing systems or computer systems using a cooling device (100) according to claims 1 to 13, wherein the cooling device (100) comprises a passive cooling system (11) and an active cooling system (12), wherein the cooling device (100) comprises two separate cooling circuits (K1, K2), wherein the passive cooling system (11) comprises a first cooling circuit (K1) with a first liquid coolant, preferably water or a glycol mixture and the active cooling system (12) comprises a second cooling circuit (K2) with a second coolant, preferably a refrigerant,
**characterised in that**
the passive cooling system (11) operates with predefined cooling temperature and that the active cooling system (12) switches on when the predefined cooling temperature of the passive cooling system (11) is exceeded and operates down to the predefined cooling temperature, wherein both cooling systems (11, 12) are functionally cooperating, wherein the cooling is carried out by a combined heat exchanger (WT1), which operates both as condenser for the active cooling system and as heat exchanger for the passive cooling system.

15. The method according to claim 14,
**characterised in that**
- the coolant of the first cooling circuit (1) such as water, water/glycol mixture or oil, is controlled by a first magnetic valve (V1) or a second magnetic valve (V2) and during passive cooling is guided through the heat exchanger (WT1) when the first magnetic valve (V1) is open and the second magnetic valve (V2) is closed and is cooled by means of ambient air through the fan to ambient air temperature + about 10 K,
- when the desired temperature is not reached due to the occurrence of higher ambient temperature or in the event of a larger accumulation of heat, the active cooling circuit (12) is switched on when valve (V1) is closed and valve (V2) is open, and the coolant is brought to the desired temperature via the heat exchanger (evaporator) (WT2) by means of the refrigerant and
- the cooling is regulated by means of electronic thermostats, whose sensors are attached at the customers either in the container (15) and/or in two-sensor systems in the components to be cooled, wherein
- the cooling process during operation is always initiated with the passive cooling system,
- upon exceeding the desired temperature of the passive cooling system by about 2 K the unit is automatically switched over to the active cooling system, wherein the coolant is cooled to about 1 K below desired temperature of the passive cooling system,
- upon reaching this temperature, the compressor and, therefore, the active cooling system is switched off and
- when the temperature increases again, the cooling process is initiated again with starting of the passive cooling system.

16. The method according to any one of the preceding claims 14 or 15,
**characterised in that**
the active cooling system is switched on at times of weak load with low cooling requirement or at low ambient temperatures and inadequate passive cooling system.

17. Use of a cooling device (100) according to any one of the preceding claims 1 to 13 in an outdoor unit.

## Revendications

1. Appareil frigorifique (100) pour enceinte contenant des pièces dégageant de la chaleur comme une armoire électronique, une armoire de commande (10), des systèmes d'enceinte ou informatiques, l'appareil frigorifique (100) présentant un système frigorifique passif (11) et un système frigorifique actif (12),
les deux systèmes frigorifiques (11, 12) étant logés dans une enceinte d'appareil frigorifique (13), l'appareil frigorifique (100) présentant deux circuits frigorifiques séparés (K1, K2), le système frigorifique passif (11) contenant un premier circuit frigorifique (K1) contenant un premier fluide réfrigérant liquide, de préférence de l'eau ou un mélange de glycol, et le système frigorifique actif (12) un second circuit frigorifique (K2) contenant un second fluide réfrigérant, de préférence un fluide frigorigène, **caractérisé en ce que** le système frigorifique passif (11) fonctionne à une température de réfrigération prédéfinie et que le système frigorifique actif (12) se met en marche en cas de dépassement de la température de réfrigération prédéfinie du système frigorifique passif (11) et descend la température de réfrigération prédéfinie,
les deux systèmes frigorifiques (11, 12) coopérant au niveau fonctionnel, la réfrigération étant assurée par un échangeur de chaleur combiné (WT1) qui fait office aussi bien de condensateur pour le système frigorifique actif (12) que d'échangeur de chaleur pour le système frigorifique passif (11).

2. Appareil frigorifique selon la revendication 1,
**caractérisé en ce que**
les deux systèmes frigorifiques (11, 12) sont réfrigérés avec le même ventilateur (17).

3. Appareil frigorifique selon la revendication 2,
**caractérisé en ce que**
le fluide réfrigérant réchauffé est refroidi à une température ambiante d'environ + 10 K par la soufflerie réfrigérante (17).

4. Appareil frigorifique selon une des revendications précédentes,
**caractérisé en ce que**
le système frigorifique passif (11) et le système frigorifique actif (12) sont reliés au niveau thermique par au moins un échangeur de chaleur (WT1, WT2).

5. Appareil frigorifique selon les revendications 3 et 4,
**caractérisé en ce que**
la soufflerie réfrigérante (17) est conçue pour réfrigérer l'échangeur de chaleur (WT1).

6. Appareil frigorifique selon une des revendications précédentes,
**caractérisé en ce que**
le système frigorifique actif (12) contient un vaporisateur de fluide réfrigérant (WT2) avec un compresseur en aval (30).

7. Appareil frigorifique selon une des revendications 4 à 6,
**caractérisé en ce**
**qu'**il est prévu second échangeur de chaleur/condensateur combiné (WT2) qui relie les deux systèmes frigorifiques au niveau thermique.

8. Appareil frigorifique selon une des revendications précédentes,
**caractérisé en ce que**
le fluide réfrigérant du système frigorifique passif (11) est refroidi jusqu'à ce qu'il ait une température telle qu'elle rende indispensable une autre réfrigération par le système frigorifique actif (12) à l'aide duquel le fluide réfrigérant peut être refroidi à température ambiante.

9. Appareil frigorifique selon une des revendications précédentes,
**caractérisé par** une qualité telle que le système frigorifique passif (11) démarre automatiquement à partir d'une première température prédéfinie (T1), que le système frigorifique actif (12) démarre à partir d'une seconde température prédéfinie (T2), la seconde température (T2) étant supérieure, en particulier supérieure d'environ 2 à 10 K, à la première température (T1).

10. Appareil frigorifique selon la revendication 9,
**caractérisé en ce que**
le système frigorifique actif (12) se coupe à nouveau si la température réelle chute en-dessous de la première température (T1), en particulier environ 1 à 2 K en-dessous de celle-ci.

11. Appareil frigorifique selon la revendication 9 ou 10,
**caractérisé en ce que**
le fluide réfrigérant du système frigorifique passif est refroidi uniquement par le fluide réfrigérant passif d'au moins 10 K.

12. Appareil frigorifique selon une des revendications précédentes,
**caractérisé par** un réservoir (14) pour le fluide réfrigérant du système frigorifique passif (11), réservoir dans lequel un capteur de température (18) est disposé pour mesurer la température du fluide réfrigérant, le capteur de température étant raccordé à un dispositif de commande pour la commande d'un compresseur (30) et des soupapes (V1, V2).

13. Appareil frigorifique selon une des revendications précédentes,
**caractérisé en ce que**
l'enceinte de l'appareil frigorifique contient une conduite externe de fluide réfrigérant (35) pour le fluide réfrigérant réchauffé et une conduite externe de fluide réfrigérant (36) pour le fluide réfrigérant refroidi, ces conduites (35, 36) étant conçues avec un échangeur de chaleur destiné à l'enceinte à réfrigérer et disposé en dehors de l'enceinte de l'appareil frigorifique telle qu'une enceinte d'armoire de commande et similaires, le circuit frigorifique (K2) du système frigorifique actif (12) étant logé intégralement dans l'enceinte de l'appareil frigorifique (13).

14. Procédé de réfrigération d'une enceinte contenant des pièces dégageant de la chaleur comme une armoire électronique, une armoire de commande (10), des systèmes d'enceinte ou informatiques, en utilisant un appareil frigorifique (100) selon les revendications 1 à 13, l'appareil frigorifique (100) présentant un système frigorifique passif (11) et un système frigorifique actif (12), l'appareil frigorifique (100) présentant deux circuits frigorifiques séparés (K1, K2), le système frigorifique passif (11) contenant un premier circuit frigorifique (K1) contenant un premier fluide réfrigérant liquide, de préférence de l'eau ou un mélange de glycol, et le système frigorifique actif (12) contenant un second circuit frigorifique (K2) contenant un second fluide réfrigérant, de préférence un fluide frigorigène,
**caractérisé en ce que**
le système frigorifique passif (11) fonctionne à une température de réfrigération prédéfinie et que le système frigorifique actif (12) se met en marche en cas de dépassement de la température de réfrigération prédéfinie du système frigorifique passif (11) et descend à la température de réfrigération prédéfinie,
les deux systèmes frigorifiques (11, 12) coopérant au niveau fonctionnel, la réfrigération étant assurée par un échangeur de chaleur combiné (WT1) qui fait office aussi bien de condensateur pour le système frigorifique actif que d'échangeur de chaleur pour le système frigorifique passif.

15. Procédé selon la revendication 14,
**caractérisé en ce que**
- le fluide réfrigérant du premier circuit frigorifique (1), tel que de l'eau, un mélange de glycol ou de l'huile, est commandé par une première soupape magnétique (V1) ou une seconde soupape magnétique (V2) et que, en cas de réfrigération passive, passe par l'échangeur de chaleur (WT1) alors que la première soupape magnétique (V1) est ouverte et la seconde soupape magnétique (V2) fermée et est refroidi au moyen de l'air ambiant par le ventilateur à la température ambiante + environ 10 K,
- en cas de non-atteinte de la température théorique suite à l'apparition d'une température ambiante plus élevée ou en cas de plus fort dégagement de chaleur, le circuit frigorifique actif (12) se met en marche alors que la soupape (V1) est fermée et la soupape (V2) est ouverte et que le fluide réfrigérant est amené à la température théorique à l'aide de l'échangeur de chaleur (vaporisateur) (WT2) au moyen du fluide frigorigène et que
- le réglage de la réfrigération est effectué au moyen de thermostats électroniques dont les sondes sont installées chez le client soit dans le réservoir (15) et/soit, pour les systèmes à deux sondes, dans les pièces à refroidir,
- l'opération de réfrigération en cours de fonctionnement débutant toujours par le système frigorifique passif,
- l'appareil passant automatiquement au système frigorifique actif en cas de dépassement à raison d'environ 2 K, le fluide réfrigérant étant refroidi à environ 1 K en-dessous de la température théorique du système frigorifique passif,
- le compresseur et donc le système frigorifique actif se coupant à l'atteinte de cette température, et
- l'opération de réfrigération étant de nouveau initiée avec démarrage du système frigorifique passif en cas de nouvelle hausse de la température.

16. Procédé selon une des revendications précédentes 14 ou 15,
**caractérisé en ce que**,
pendant les périodes de faible charge avec faible besoin de réfrigération ou dans le cas de températures ambiantes basses et dans le cas où le système frigorifique passif ne suffit pas, le système frigorifique actif se met en marche.

17. Utilisation d'un appareil frigorifique (100) selon une des revendications précédentes 1 à 13 dans un appareil d'extérieur.
